# EUROPÄISCHE PATENTSCHRIFT

(11) **EP 1 360 143 B1**
(45) Veröffentlichungstag und Bekanntmachung des Hinweises auf die Patenterteilung: **16.11.2005**
(21) Anmeldenummer: 02708202.3
(22) Anmeldetag: 04.02.2002
(51) Int. Cl.: B81B 3/00

(54) **VERFAHREN ZUM ERZEUGEN VON OBERFLÄCHENMIKROMECHANIKSTRUKTUREN UND SENSOR**
METHOD FOR PRODUCING SURFACE MICROMECHANICAL STRUCTURES, AND SENSOR
PROCEDE DE REALISATION DE STRUCTURES SUPERFICIELLES MICROMECANIQUES, ET CAPTEUR

(30) Priorität: 06.02.2001 DE 10105187
(43) Veröffentlichungstag der Anmeldung: 12.11.2003
(73) Patentinhaber: ROBERT BOSCH GMBH, 70442 Stuttgart (DE)
(72) Erfinder: FISCHER, Frank, 72810 Gomaringen (DE); FREY, Wilhelm, Palo Alto, CA 94304 (US); METZGER, Lars, 72458 Albstadt (DE)
(86) Internationale Anmeldenummer: PCT/DE2002/000397
(87) Internationale Veröffentlichungsnummer: WO 2002/062698

(56) Entgegenhaltungen:
- WO-A-94/18697
- WO-A-96/08036
- DE-A- 4 420 962
- DE-A- 19 847 455
- US-A- 5 756 901
- PATENT ABSTRACTS OF JAPAN vol. 018, no. 480 (E-1603), 8. September 1994 (1994-09-08) -& JP 06 163872 A (CANON INC), 10. Juni 1994 (1994-06-10)

## Beschreibung

Die vorliegende Erfindung betrifft ein Verfahren zum Erzeugen von Oberflächenmikromechanikstrukturen mit hohem Aspektverhältnis, bei dem zwischen einem Substrat und einer Funktionsschicht zumindest eine Opferschicht vorgesehen ist, wobei in der Funktionsschicht durch einen Plasma-Ätzprozess Gräben vorgesehen werden, von denen zumindest einige Oberflächenbereiche der Opferschicht freilegen. Weiterhin betrifft die vorliegende Erfindung einen Sensor, insbesondere einen Beschleunigungs- oder Drehratensensor, mit mikromechanischen Strukturen, die Elektroden umfassen, die durch Gräben voneinander getrennt sind.

### Stand der Technik

Die Erfindung geht von einem gattungsgemäßen Verfahren und einem gattungsgemäßen Sensor aus, wie sie in der DE 195 37 814 A1 beschrieben sind, deren Inhalt durch diese Bezugnahme zum Bestandteil des Offenbarungsgehaltes der vorliegenden Anmeldung gemacht wird. Allgemein werden in der Oberflächenmikromechanik Tiefenätzverfahren angewendet, mit denen Bauelementstrukturen mit relativ hohem Aspektverhältnis hergestellt werden können. Unter dem Aspektverhältnis versteht man dabei das Verhältnis der Tiefe eines Grabens beziehungsweise einer Ausnehmung zur lateralen Abmessung. Ein bekanntes Tiefenstrukturierungsverfahren in Form eines Plasma-Ätzverfahrens ist beispielsweise in der DE 42 41 045 beschrieben, deren Inhalt durch diese Bezugnahme ebenfalls zum Bestandteil des Offenbarungsgehaltes der vorliegenden Anmeldung gemacht wird. Mit dem in der DE 42 41 045 beschriebenen Trenchverfahrens können bereits Gräben mit einer Grabenmindestbreite von 1 µm geöffnet werden. Wie bei allen Plasma-Ätzverfahren ist die Ätzrate abhängig von den Strukturabständen. Bei schmalen Ätzöffnungen sinkt die Ätzrate deutlich gegenüber der Ätzrate, wie sie mit breiten Ätzöffnungen erzielt werden kann. Erst bei Abständen oberhalb von ungefähr 10 µm ist die Ätzrate im Wesentlichen unabhängig von den Strukturabständen. Zusammenfassend lässt sich feststellen, dass mit bisher bekannten Verfahren Abstände von weniger als 1 µm zumindest nicht sicher reproduzierbar beziehungsweise nicht fertigungssicher hergestellt werden können. Beispielsweise bei Sensoren mit mikromechanischen Strukturen, die Elektroden umfassen, die durch Gräben voneinander getrennt sind, wirken sich große Elektrodenabstände jedoch negativ auf die elektrische Empfindlichkeit des Sensors aus.

Aus der internationalen Patentanmeldung WO-A-9418697 ist ein Beschleunigungssensor mit mikromechanischen Strukturen und seine Herstellung bekannt. Der Sensor weist auf einem einkristallinen Substrat eine dielektrische Maske auf, mittels derer im Herstellungsprozess Isolationsgräben und mikromechanischen Strukturen festgelegt werden. Auf die geschaffenen Strukturen ist eine weitere Schutzschicht aufgebracht. Schließlich werden die Strukturen zur Schaffung von Kondensatorelektroden mit Aluminium beschichtet.

Die Offenlegungsschrift DE 19847455 A 1 offenbart ein Verfahren zur Herstellung von Oberflächenmikromechanikstrukturen mit hohem Aspektverhältnis, bei dem zwischen einem Substrat und einer Funktionsschicht eine Opferschicht vorgesehen wird, wobei in der Funktionsschicht durch einen Plasma-Ätzprozess Graben vorgesehen werden, von denen einige Oberflächenbereiche der Opferschicht freiliegen und auf den Seitenwänden der Gräben, nicht jedoch auf den freigelegten Oberflächenbereichen der Opferschicht, eine weitere teflonartige Schicht abgeschieden wird.

### Vorteile der Erfindung

Dadurch, dass bei dem erfindungsgemäßen Verfahren vorgesehen ist, dass zur Vergrößerung des Aspektverhältnisses der Gräben zumindest abschnittsweise auf den Seitenwänden der Gräben, nicht jedoch auf den freigelegten Oberflächenbereichen der Opferschicht, eine weitere Schicht abgeschieden wird, können kleinere Grabenbreiten beziehungsweise Strukturabstände erzielt werden, als dies mit den bekannten Verfahren möglich ist. Dies ermöglicht es beispielsweise, die elektrische Empfindlichkeit von Sensoren zu erhöhen. Die weitere Schicht kann in vielen Fällen durch einen kostengünstigen Batch-Prozess abgeschieden werden, der keine aufwendige Vorreinigung und keine zusätzliche Maskierungsebene erfordert. Allgemein können die Oberflächenmikromechanikstrukturen durch Verfahrensschritte gebildet werden, die aus der Halbleitertechnik gut bekannt sind und die daher hier nicht näher erläutert werden.

Bei dem erfindungsgemäßen Verfahren besteht die weitere Schicht aus Germanium, die Funktionsschicht besteht aus Si und die Opferschicht besteht aus SiO₂.

Insbesondere in diesem Fall ist bei dem erfindungsgemäßen Verfahren vorgesehen, dass die weitere Schicht durch einen LPCVD-Prozess (Low Pressure Chemical Vapour Deposition) abgeschieden wird. Im Zusammenhang mit der LPCVD-Abscheidung von Ge ist bekannt, dass Ge nur auf Si nukleiert, nicht dagegen auf SiO₂. Dies führt dazu, dass zumindest auf den Seitenwänden der Gräben Ge abgeschieden wird, während auf den freigelegten Oberflächenbereichen der Opferschicht kein Ge abgeschieden wird. Dies ermöglicht es, dass bei späteren Verfahrensschritten ein Ätzmittel an die Opferschicht 2 herangebracht wird, um diese zu ätzen.

Im Zusammenhang mit dem erfindungsgemäßen Verfahren ist vorzugsweise weiterhin vorgesehen, dass die weitere Schicht bei Temperaturen im Bereich von 350 °C und 500 °C abgeschieden wird. Dieser Temperaturbereich ist beispielsweise für die LPCVD-Abscheidung von Ge gut geeignet.

Darüber hinaus ist bei dem erfindungsgemäßen Verfahren vorzugsweise vorgesehen, dass die weitere Schicht aus GeH₄ abgeschieden wird, um die erwünschte Schicht aus Ge zu erhalten.

Das erfindungsgemäße Verfahren sieht vorzugsweise vor, dass die Schichtdicke der weiteren Schicht im Bereich von 0,05 µm bis 2 µm liegt. Beispielsweise im Zusammenhang mit Sensoren kann durch die Schichtdicke der weiteren Schicht der Elektrodenabstand effektiv eingestellt werden.

Nach dem erfindungsgemäßen Abscheiden der weiteren Schicht weisen die Gräben vorzugsweise zumindest abschnittsweise eine Breite von weniger als 1 µm auf, wobei diese Breite bei besonders bevorzugten Ausführungsformen im Bereich zwischen 0,1 µm und 1 µm liegen kann.

Bei bestimmten Ausführungsformen des erfindungsgemäßen Verfahrens kann vorgesehen sein, dass eine im Zusammenhang mit dem Plasma-Ätzverfahren abschnittsweise auf der Funktionsschicht vorgesehene Maskierungsschicht vor der Abscheidung der weiteren Schicht entfernt wird. In diesem Fall kann die weitere Schicht auch auf den Oberflächenbereichen der Funktionsschicht abgeschieden werden, die vorher von der Maskierungsschicht bedeckt waren.

Bei anderen Ausführungsformen des erfindungsgemäßen Verfahrens kann im Gegensatz hierzu vorgesehen sein, dass eine im Zusammenhang mit dem Plasma-Ätzverfahren abschnittsweise auf der Funktionsschicht vorgesehene Maskierungsschicht vor der Abscheidung der weiteren Schicht nicht entfernt wird. In diesem Fall ist es möglich, die weitere Schicht nur auf den Seitenwänden der in herkömmlicher Weise gebildeten Gräben vorzusehen, wobei die die Funktionsschicht noch bedeckende Maskierungsschicht später entfernt werden kann.

Insbesondere wenn das erfindungsgemäße Verfahren zur Herstellung eines Sensors eingesetzt wird, kann weiterhin vorgesehen sein, dass zwischen der Opferschicht und dem Substrat eine Leiterschicht vorgesehen ist, die durch die Opferschicht abschnittsweise gegenüber der Funktionsschicht isoliert ist, wie dies beispielsweise aus der genannten DE 195 37 814 A1 bekannt ist.

Dadurch, dass bei dem erfindungsgemäßen Sensor vorgesehen ist, dass die Gräben zumindest abschnittsweise eine Breite von weniger als 1 µm aufweisen, kann beispielsweise die elektrische Empfindlichkeit eines entsprechenden Sensors gegenüber dem Stand der Technik deutlich verbessert werden.

In diesem Zusammenhang ist vorzugsweise vorgesehen, dass die Gräben zumindest abschnittsweise eine Breite im Bereich von 0,1 µm und 1µm aufweisen, je nach Anwendungsfall.

Bei der bevorzugten Ausführungsform des erfindungsgemäßen Sensors ist vorgesehen, dass die Seitenwände der Gräben zumindest abschnittsweise durch eine Schicht aus Ge gebildet sind, die beispielsweise durch das erfindungsgemä-ße Verfahren erzeugt wurde.

In diesem Zusammenhang ist bei dem erfindungsgemäßen Sensor vorzugsweise weiterhin vorgesehen, dass die die Seitenwände der Gräben bildende Schicht aus Ge auf einer Schicht aus Si abgeschieden ist. In diesem Fall kann die Schicht aus Ge in vorteilhafter Weise durch einen LPCVD-Prozess hergestellt werden.

Bei dem erfindungsgemäßen Sensor ist vorzugsweise weiterhin vorgesehen, dass die Elektroden mit einem Substrat oder der Leitschicht verbunden sind, beispielsweise einem Si-Substrat. Die Verbindung kann dabei durch zurückgelassene. Abschnitte einer Opferschicht gebildet sein, wobei zwischen der Opferschicht und dem Substrat beispielsweise eine Leiterschicht zumindest abschnittsweise zusätzlich vorgesehen sein kann.

Im Zusammenhang mit dem erfindungsgemäßen Sensor ist vorzugsweise weiterhin vorgesehen, dass zumindest einige der mit dem Substrat verbundenen Elektroden zumindest abschnittsweise beweglich sind, wie dies beispielsweise in der genannten DE 195 37 814 A1 gezeigt und beschrieben ist.

### Zeichnungen

Die Erfindung wird nachfolgend anhand der zugehörigen Zeichnungen noch näher erläutert.

Es zeigen:
- Figur 1: eine schematische Darstellung einer Oberflächenmikrostruktur, wie sie durch ein gattungsgemäßes Verfahren erzielt werden kann,
- Figur 2: die Oberflächemikrostruktur gemäß Figur 1 nach der Durchführung einer ersten Ausführungsform des erfindungsgemäßen Verfahrens,
- Figur 3: die Oberflächenmikrostruktur von Figur 1 nach der Durchführung einer zweiten Ausführungsform des erfindungsgemäßen Verfahrens, und
- Figur 4: die Oberflächenmikrostruktur von Figur 3 nach der Durchführung weiterer Verfahrensschritte.

### Beschreibung der Ausführungsbeispiele

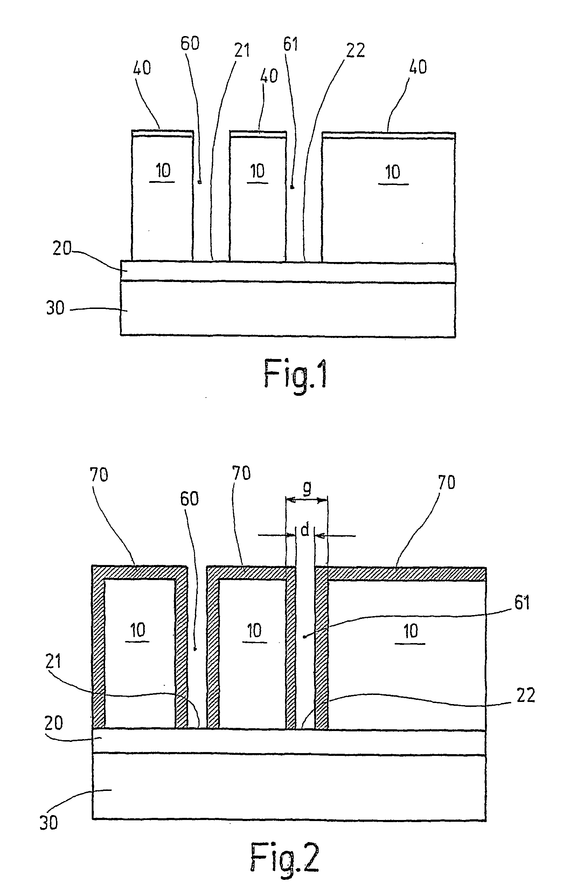

Figur 1 zeigt eine schematische Darstellung einer Oberflächenmikrostruktur, wie sie durch bekannte Verfahren erzielt werden kann, beispielsweise entsprechend der Lehre der genannten DE 195 37 814 A1. Dabei ist ein Substrat 30 vorgesehen dass beispielsweise durch Si gebildet sein kann. Aufgrund der angepassten thermischen Ausdehnung ist Si als Substratmaterial in besonderer Weise geeignet, da so thermisch bedingte Verspannungen, die beispielsweise die Kennlinie eines Sensors beeinflussen können, vermieden werden. Auf dem Substrat 30 ist eine Opferschicht 20 vorgesehen, die beispielsweise aus SiO₂ gebildet sein kann. Zum Abscheiden der SiO₂-Schicht können die aus der Halbleitertechnik bekannten Abscheideprozesse zur Abscheidung von dielektrischen Schichten genutzt werden. Auf der SiO₂-Opferschicht 20 ist eine Funktionsschicht 10 vorgesehen, bei der es sich vorzugsweise um eine Si-Opferschicht 20 handelt. Gemäß der Darstellung von Figur 1 ist die Si-Funktionsschicht 10 bereits strukturiert und zwar durch Gräben 60, 61, die die Si-Funktionsschicht 10 in einzelne Abschnitte beziehungsweise Strukturen unterteilt. Die Gräben 60, 61 werden durch ein Plasma-Ätzverfahren ausgebildet, wobei vor der Durchführung des eigentlichen Ätzvorgangs eine Maskierungsschicht 40 auf der Si-Funktionsschicht 10 aufgebracht wird, wie dies aus der Halbleitertechnik bekannt ist. Die Gräben 60, 61 legen nach der Durchführung des Plasma-Ätzverfahrens Oberflächenbereiche 21, 22 der SiO₂-Opferschicht 20 frei. Die Breite der Gräben beträgt dabei bedingt durch das Plasma-Ätzverfahren mindestens 1 µm, wie dies eingangs bereits erläutert wurde.

Figur 2 zeigt die Oberflächemikrostruktur gemäß Figur 1 nach der Durchführung einer ersten Ausführungsform des erfindungsgemäßen Verfahrens. Ausgehend von der Oberflächenmikrostruktur, wie sie in Figur 1 dargestellt ist, gelangt man zu der Oberflächenmikrostruktur gemäß Figur 2, indem zunächst die Maskierungsschicht 4 in geeigneter Weise von der Si-Funktionsschicht 10 entfernt wird. Anschließend wird beispielsweise durch einen LPCVD-Prozess eine weitere Schicht 70 in Form einer Ge-Schicht aus GeH₄ abgeschieden. Dies kann bei Temperaturen zwischen 350 °C und 500 °C erfolgen. Da Ge wie erwähnt nur auf Si nukleiert und nicht auf SiO₂, wird auf den freigelegten Oberflächenbereichen 21, 22 der SiO₂-Opferschicht 20 kein Ge abgeschieden, so dass man die in Figur 2 dargestellte Oberflächenmikrostruktur erhält. Die Ge-Schicht 70 wird mit einer Schichtdicke im Bereich von 0,05 µm bis 2 µm abgeschieden. Über die Schichtdicke der Ge-Schicht 70 kann die Breite d der Gräben 60, 61, die beispielsweise bei einem Sensor dem Elektrodenabstand entsprechen kann, in gewünschter Weise eingestellt, das heißt bezüglich der durch das Plasma-Ätzverfahren hervorgerufenen ursprünglichen Breite g der Gräben 60, 61 verringert werdem.

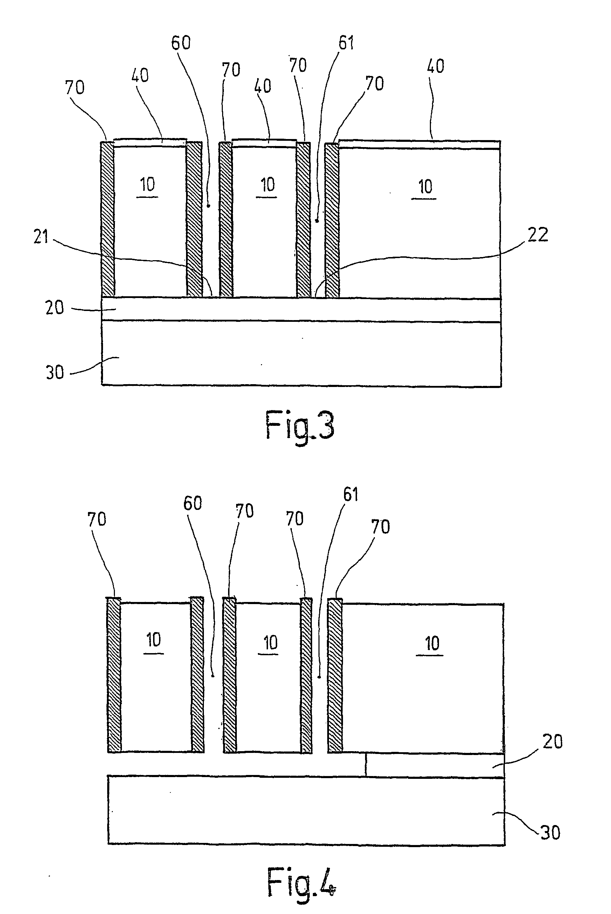

Figur 3 zeigt die Oberflächenmikrostruktur von Figur 1 nach der Durchführung einer zweiten Ausführungsform des erfindungsgemäßen Verfahrens. Die Ausführungsform gemäß Figur 3 unterscheidet sich von der gemäß Figur 2 dadurch, dass die Maskierungsschicht 40 vor der Abscheidung der Ge-Schicht nicht entfernt wird. Daher wird die Ge-Schicht 70 nur an den Seitenwänden der Gräben 60, 61 abgeschieden. Da Ge wie erwähnt nicht auf SiO₂ nukleiert, wird auf den freigelegten Oberflächenbereichen 21, 22 der SiO₂-Opferschicht 20 auch in diesem Fall kein Ge abgeschieden.

Figur 4 zeigt die Oberflächenmikrostruktur von Figur 3 nach der Durchführung weiterer Verfahrensschritte. Dabei wurde ausgehend von der Darstellung gemäß Figur 3 die Maskierungsschicht 40 entfernt und die SiO₂-Opferschicht 20 derart geätzt, dass die Funktionsschicht 10 zusammen mit der Ge-Schicht 70 freibewegliche Strukturen bildet, die mit einem geringen Abstand zueinander angeordnet sind. Wenn die durch die Si-Funktionsschicht 10 und die Ge-Schicht 70 gebildeten Strukturen beispielsweise Elektroden eines Sensors bilden, kann deren Anordnung mit geringem Abstand zu einer Erhöhung der elektrischen Empfindlichkeit des Sensors führen. Obwohl dies in der Figur nicht dargestellt ist, kann vorgesehen sein, dass zwischen der SiO₂-Opferschicht 20 und dem Si-Substrat 30 eine Leiterschicht ausgebildet ist, die durch die SiO₂-Opferschicht 20 abschnittsweise gegenüber der Funktionsschicht 10 isoliert ist, wie dies in ähnlicher Weise in der erwähnten DE 195 37 814 A1 gezeigt ist. Bezüglich einer möglichen Ausgestaltung eines Sensors wird ebenfalls auf die entsprechenden Ausführungen in dieser Druckschrift verwiesen.

Durch die vorliegende Erfindung können beispielsweise Elektrodenabstände und die Distanz zwischen den mechanisch funktionalen Komponenten, wie beispielsweise Anschlagsbegrenzungen, derart eingestellt werden, dass sich kleinere Abstände beziehungsweise Distanzen ergeben, als dies bisher möglich war. Insbesondere wenn die weitere Schicht 70 durch einen LPCVD-Prozess erzeugt wird, kann dies in Form eines Batch-Prozesses erfolgen, der nur geringe Kosten verursacht und weder eine aufwendige Vorreinigung noch eine zusätzliche Maskierungsebene erfordert.. Weiterhin kann es bei bestimmten Ausführungsformen erwünscht sein, dass die weitere Schicht nur in bestimmten Abschnitten der Seitenwände der Graben 60, 61 abgeschieden wird. Wenn die weitere Schicht 70 durch eine über einen LPCVD-Prozess abgeschiedene Ge-Schicht gebildet wird, können zu diesem Zweck bestimmte Bereiche der Seitenwände der Gräben 60, 61, auf denen keine weitere Schicht 70 abgeschieden werden soll, mit einem Oxid bedeckt werden.

Die vorhergehende Beschreibung der Ausführungsbeispiele gemäß der vorliegenden Erfindung dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihre Äquivalente zu verlassen.

## Patentansprüche

1. Verfahren zum Erzeugen von Oberflächenmikromechanikstrukturen mit hohem Aspektverhältnis, bei dem zwischen einem Substrat (30) und einer Funktionsschicht (10) zumindest eine Opferschicht (20) vorgesehen wird, wobei in der Funktionsschicht (10) durch einen Plasma-Ätzprozess Gräben (60, 61) vorgesehen werden, von denen zumindest einige Oberflächenbereiche (21, 22) der Opferschicht (20) freilegen, wobei zur Vergrößerung des Aspektverhältnisses der Gräben zumindest abschnittsweise auf den Seitenwänden der Gräben, nicht jedoch auf den freigelegten Oberflächenbereichen (21, 22) der Opferschicht (20), eine weitere Schicht (70) abgeschieden wird, **dadurch gekennzeichnet dass** die weitere Schicht (70) aus Ge besteht, und die Opferschicht (20) aus Silizium Dioxide besteht.

2. Verfahren nach einem der vorhergehenden Ansprüche, **dadurch gekennzeichnet, dass** die Funktionsschicht (10) aus Si besteht.

3. Verfahren nach einem der vorhergehenden Ansprüche, **dadurch gekennzeichnet, dass** die weitere Schicht (70) durch einen LPCVD-Prozess abgeschieden wird.

4. Verfahren nach einem der vorhergehenden Ansprüche, **dadurch gekennzeichnet, dass** die weitere Schicht (70) bei Temperaturen im Bereich von 350°C und 500°C abgeschieden wird.

5. Verfahren nach einem der vorhergehenden Ansprüche, **dadurch gekennzeichnet, dass** die weitere Schicht (70) aus GeH₄ abgeschieden wird.

6. Verfahren nach einem der vorhergehenden Ansprüche, **dadurch gekennzeichnet, dass** die Schichtdicke der weiteren Schicht (70) im Bereich von 0,05 µm bis 2 µm liegt.

7. Verfahren nach einem der vorhergehenden Ansprüche, **dadurch gekennzeichnet, dass** die Gräben (60, 61) nach dem abscheiden der weiteren Schicht (70) zumindest abschnittsweise eine Breite von weniger als 1 µm aufweisen.

8. verfahren nach einem der vorhergehenden Ansprüche, **dadurch gekennzeichnet, dass** die Gräben (60, 61) nach dem abscheiden der weiteren Schicht (70) zumindest abschnittsweise eine Breite im Bereich von 0,1 µm und 1 µm aufweisen.

9. Verfahren nach einem der vorhergehenden Ansprüche, **dadurch gekennzeichnet, dass** eine im Zusammenhang mit dem Plasma-Ätzverfahren abschnittsweise auf der Funktionsschicht (10) vorgesehene Maskierungsschicht (40) vor der Abscheidung der weiteren Schicht (70) entfernt wird.

10. verfahren nach einem der vorhergehenden Ansprüche, **dadurch gekennzeichnet, dass** eine im Zusammenhang mit dem Plasma-Ätzverfahren abschnittsweise auf der Funktionsschicht (10) vorgesehene Maskierungsschicht (40) vor der Abscheidung der weiteren Schicht (70) nicht entfernt wird.

11. Verfahren nach einem der vorhergehenden Ansprüche, **dadurch gekennzeichnet, dass** zwischen der Opferschicht (20) und dem Substrat (30) eine Leitschicht vorgesehen ist, die durch die Opferschicht (20) abschnittsweise gegenüber der Funktionsschicht (10) isoliert ist.

12. Sensor, insbesondere Beschleunigungs- oder Drehratensensor, mit mikromechanischen Strukturen, die Elektroden umfassen, die durch Gräben voneinander getrennt sind, wobei die Gräben zumindest abschnittsweise eine Breite von weniger als 1 µm aufweisen, und die Seitenwände der Gräben unmittelbar mit einer Schicht aus Germanium beschichtet sind.

13. Sensor nach Anspruch 12, **dadurch gekennzeichnet, dass** die Gräben zumindest abschnittsweise eine Breite im Bereich von 0,1 µm und 1 µm aufweisen.

14. Sensor nach einem der Ansprüche 12 bis 13, **dadurch gekennzeichnet, dass** die die Seitenwände der Gräben bildende Schicht aus Ge auf einer Schicht aus Si abgeschieden ist.

15. sensor nach Anspruch 12, **dadurch gekennzeichnet, dass** die Elektroden mit einem Substrat oder der Leitschicht verbunden sind.

16. Sensor nach Anspruch 12, **dadurch gekennzeichnet, dass** zumindest einige der mit dem Substrat verbundenen Elektroden zumindest abschnittsweise beweglich sind.

## Claims

1. Process for producing surface micromechanical structures with a high aspect ratio, in which at least one sacrificial layer (20) is provided between a substrate (30) and a functional layer (10), trenches (60, 61), of which at least some surface regions (21, 22) of the sacrificial layer (20) are uncovered, being provided in the functional layer (10) by a plasma etching process, a further layer (70) being deposited at least on sections of the side walls of the trenches but not on the uncovered surface regions (21, 22) of the sacrificial layer (20) in order to increase the aspect ratio of the trenches, **characterized in that** the further layer (70) consist of Ge and the sacrificial layer (20) consists of silicon dioxide.

2. Process according to one of the preceding claims, **characterized in that** the functional layer (10) consists of Si.

3. Process according to one of the preceding claims, **characterized in that** the further layer (70) is deposited by a LPCVD process.

4. Process according to one of the preceding claims, **characterized in that** the further layer (70) is deposited at temperatures in the range from 350°C to 500°C.

5. Process according to one of the preceding claims, **characterized in that** the further layer (70) is deposited from GeH₄.

6. Process according to one of the preceding claims, **characterized in that** the layer thickness of the further layer (70) is in the range from 0.05 µm to 2 µm.

7. Process according to one of the preceding claims, **characterized in that** the trenches (60, 61), following the deposition of the further layer (70), at least in sections are less than 1 µm wide.

8. Process according to one of the preceding claims, **characterized in that** the trenches (60, 61), following the deposition of the further layer (70), at least in sections are from 1.1 µm to 1 µm wide.

9. Process according to one of the preceding claims, **characterized in that** a masking layer (40), which is provided on sections of the functional layer (10) as part of the plasma etching process, is removed prior to the deposition of the further layer (70).

10. Process according to one of the preceding claims, **characterized in that** a masking layer (40) which is provided on sections of the functional layer (10) as part of the plasma etching process is not removed prior to the deposition of the further layer (70).

11. Process according to one of the preceding claims, **characterized in that** a conductive layer is provided between the sacrificial layer (20) and the substrate (30) which conductive layer in sections is insulated from the functional layer (10) by the sacrificial layer (20) .

12. Sensor, in particular acceleration or rotation rate sensor, having micromechanical structures which comprise electrodes that are separated from one another by trenches, the trenches, at least in sections, being less than 1 µm wide, and the side walls of the trenches being directly coated with a layer of germanium.

13. Sensor according to Claim 12, **characterized in that** the trenches, at least in sections, are from 0.1 µm to 1 µm wide.

14. Sensor according to one of Claims 12 to 13, **characterized in that** the layer of Ge which forms the side walls of the trenches is deposited on a layer of Si.

15. Sensor according to Claim 12, **characterized in that** the electrodes are connected to a substrate or the conductive layer.

16. Sensor according to Claim 12, **characterized in that** at least some of the electrodes connected to the substrate are movable at least in sections.

## Revendications

1. Procédé de réalisation de structures superficielles micromécaniques ayant un rapport d'aspect élevé, dans lequel il est prévu entre un substrat (30) et une couche fonctionnelle (10) au moins une couche sacrificielle (20), des creux (60, 61) étant réalisés dans la couche fonctionnelle (10) par un procédé de gravure par plasma, parmi lesquels au moins certaines zones superficielles (21, 22) de la couche sacrificielle (20) sont libres, une couche supplémentaire (70) étant déposée au moins par endroits sur les parois latérales des creux, mais pas sur les zones superficielles libres (21, 22) de la couche sacrificielle (20) pour augmenter le rapport d'aspect des creux,
**caractérisé en ce que**
la couche supplémentaire (70) se compose de Ge tandis que la couche sacrificielle (20) se compose de dioxyde de silicium.

2. Procédé selon l'une quelconque des revendications précédentes,
**caractérisé en ce que**
la couche fonctionnelle (10) se compose de Si.

3. Procédé selon l'une quelconque des revendications précédentes,
**caractérisé en ce que**
la couche supplémentaire (70) est déposée par un procédé de dépôt chimique en phase vapeur basse pression.

4. Procédé selon l'une quelconque des revendications précédentes,
**caractérisé en ce que**
la couche supplémentaire (70) est déposée à des températures comprises dans une plage de 350°C à 500°C.

5. Procédé selon l'une quelconque des revendications précédentes,
**caractérisé en ce que**
la couche supplémentaire (70) est déposée à partir de GeH₄.

6. Procédé selon l'une quelconque des revendications précédentes,
**caractérisé en ce que**
l'épaisseur de la couche supplémentaire (70) est comprise entre 0,05 µm et 2 µm.

7. Procédé selon l'une quelconque des revendications précédentes,
**caractérisé en ce que**
les creux (60, 61), après le dépôt de la couche supplémentaire (70), présentent au moins par endroits une largeur inférieure à 1 µm.

8. Procédé selon l'une quelconque des revendications précédentes,
**caractérisé en ce que**
les creux (60, 61), après le dépôt de la couche supplémentaire (70), présentent au moins par endroits une largeur comprise entre 0,1 µm et 1 µm.

9. Procédé selon l'une quelconque des revendications précédentes,
**caractérisé en ce qu'**
une couche de masquage (40) prévue par endroits sur la couche fonctionnelle (10) dans le cadre du procédé de gravure par plasma est éliminée avant le dépôt de la couche supplémentaire (70).

10. Procédé selon l'une quelconque des revendications précédentes,
**caractérisé en ce qu'**
une couche de masquage (40) prévue par endroits sur la couche fonctionnelle (10) dans le cadre du procédé de gravure par plasma n'est pas éliminée avant le dépôt de la couche supplémentaire (70).

11. Procédé selon l'une quelconque des revendications précédentes,
**caractérisé en ce qu'**
il est prévu entre la couche sacrificielle (20) et le substrat (30) une couche conductrice isolée par endroits de la couche fonctionnelle (10) par la couche sacrificielle (20).

12. Capteur, en particulier capteur d'accélération et de régime, doté de structures micromécaniques comportant des électrodes séparées les unes des autres par des creux, les creux présentant au moins par endroits une largeur inférieure à 1 µm, et les parois latérales des creux étant directement recouvertes par une couche de Germanium.

13. Capteur selon la revendication 12,
**caractérisé en ce que**
les creux présentent au moins par endroits une largeur comprise entre 0,1 µm et 1 µm.

14. Capteur selon l'une quelconque des revendications 12 à 13,
**caractérisé en ce que**
la couche de Ge formant les parois latérales des creux est déposée sur une couche de Si.

15. Capteur selon la revendication 12,
**caractérisé en ce que**
les électrodes sont reliées à un substrat ou à une couche conductrice.

16. Capteur selon la revendication 12,
**caractérisé en ce qu'**
au moins certaines des électrodes reliées au substrat sont mobiles au moins par endroits.
